(19)

Europäisches
Patentamt
European
Patent Office
Office européen
des brevets

(11) **EP 4 084 468 A1**

(12) **EUROPEAN PATENT APPLICATION**

(43) Date of publication:
**02.11.2022 Bulletin 2022/44**

(21) Application number: **21171195.7**

(22) Date of filing: **29.04.2021**

(51) International Patent Classification (IPC):
**H04N 5/3745** (2011.01)  **H01L 27/146** (2006.01)
**G01N 27/414** (2006.01)

(52) Cooperative Patent Classification (CPC):
**H04N 5/3745; G01N 27/4145; G01N 27/4148;**
H01L 27/14678

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Imec VZW**
**3001 Leuven (BE)**
• **Katholieke Universiteit Leuven**
**KU Leuven Research & Development**
**3000 Leuven (BE)**

(72) Inventors:
• **Siskos, Aris**
**Heverlee (BE)**
• **De Roose, Florian**
**Rumst (BE)**
• **Myny, Kris**
**Heusden-Zolder (BE)**
• **Dehaene, Wim**
**Kessel-Lo (BE)**

(74) Representative: **AWA Sweden AB**
**Box 5117**
**200 71 Malmö (SE)**

(54) **AN ACTIVE THIN-FILM CHARGE SENSOR ELEMENT**

(57)    An active thin-film charge sensor element comprising a charge collecting detector configured to detect a predetermined physical quantity and generate a corresponding intensity signal at an internal charge sensor element node. An amplifier transistor, the amplifier transistor comprising at least one gate that is electrically connected to the charge collecting detector at the internal charge sensor element node, and configured to amplify the intensity signal. A reset transistor, the reset transistor is electrically connected to the internal charge sensor element node and configured to reset the intensity signal, and wherein at least one of the amplifier transistor or reset transistor comprises a front gate and a back gate and wherein the front and back gates are configured to control the amplifier transistor or reset transistor.

Fig. 1

## Description

Technical Field

The invention relates to an active thin-film charge sensor element, more specifically to an active thin-film charge sensor element comprising an amplifier transistor and/or a reset transistor, and at least either the amplifier transistor or reset transistor comprises a front gate and a back gate and wherein the front and back gates are configured to control the amplifier transistor or reset transistor.

Background

To drive sensor elements of a charge-based sensor, such as pixels of an imager, sensor element circuits (pixel circuits) are needed in the backplane of the sensor, e.g. imager.

Large charge-based sensors, such as 10x10cm large image sensors, have previously used passive charge sensor elements (pixel sensors). However, passive pixel sensors have low conversion gain and low noise performance. Therefore, active pixel sensors (active charge sensor elements) would be preferred.

When using active charge sensor elements in a charge-based sensor array, sensor element circuits are needed for driving the charge sensor elements. Active charge-based sensor topologies use an amplifier to increase the conversion gain of the system. These topologies have either a voltage output or a current output and hence are called Voltage-Mode (VM) or Current-Mode (CM) charge sensor elements.

Known topologies are based on different configurations, all having a charge collecting detector and at least one amplifying transistor. The topology of the active charge sensor element circuit may be any of a two-transistor (2T), three-transistor (3T) or a four-transistor (4T) topology.

The use of multiple transistors in the charge sensor element results in a certain charge sensor element area for physically encompassing all the components, e.g. charge collecting detector (such as photodetector) and transistors, and at the same time amplification by the amplification transistor must be large enough to generate a gain between the intensity signal generated by the charge collecting detector and the data line signal.

Additionally, the charge sensor element area finally determines the number of active charge sensor elements that can fit in the charge-based sensor having a pre-fixed size, i.e. the charge sensor element density, such as for example the so-called pixel pitch of an image sensor. The charge sensor element density, or the number of active charge sensor elements in the charge-based sensor per unit area, will thus also determine a possible highest resolution of the charge-based sensor.

Thus, there is a need for a reduced charge sensor element area and thus a higher resolution fixed size charge-based sensor.

Summary

It is an object of the invention to at least partly overcome one or more of the above-identified limitations of the prior art. In particular, it is an object to provide a small area charge sensor element size.

The use of thin-film technology for manufacturing sensors is of interest in particular when a flexible and/or large sensor is desired. The most common applied thin-film topology is the passive charge-based sensor, because the performance of transistors has not been sufficient to enable use of active charge-based sensors. When using a passive sensor topology, an external charge-sense amplifier part of a periphery is connected to an output of a data line. Such topology increases complexity of the charge-based sensor. Furthermore, normally noise performance is low since the conversion gain is low. It is therefore required to either detect a higher sensor signal by the charge collecting detector, e.g. detecting a higher light intensity by a photodetector, or to increase the size of the passive sensor element so that the sensing area will be increased.

A particular solution using an active charge sensor element will be discussed herein and is based on the use of dual-gate transistors that consist of a front gate (FG) and a back gate (BG) in thin-film technology resulting in the active thin-film charge sensor element comprising dual gate thin-film transistors.

Hence, throughout this disclosure the use of the back gate does not correspond to a bulk gate in transistors formed on a wafer, in which the bulk gate may sometimes confusingly be referred to as the back gate. In the present disclosure, the thin-film transistors are not formed on a bulk material and the front gate and back gate provide potentials on opposite sides of a thin-film transistor, which differs from a potential provided to a bulk gate, as is in other MOSFET based sensors.

The thin-film transistor may comprise a thin film of semiconducting material, a source, a drain, and a gate. The gate may control a current from the source to the drain through the thin film. The current may be passed laterally through the thin film.

The thin-film transistor may be free of a semiconducting substrate. The thin-film transistor may instead be attached to a supporting but non-conducting substrate such as an insulating substrate, e.g. a glass substrate, an oxide substrate, or a polymer substrate. The thin-film transistor may be grown or deposited on the substrate.

Semiconducting material in a thin-film transistor may be e.g. amorphous indium-gallium-zinc-oxide (a-IGZO) or other amorphous oxide semiconductors, amorphous silicon, low-temperature polycrystalline silicon (LTPS) or organic semiconducting material.

The structural order of the material of the thin-film may be lower than single crystalline structural order.

For example, the structural order of the material of a thin-film integrated circuit including thin-film transistors may be amorphous structural order, microcrystalline structural order, or polycrystalline structural order.

The film thickness of the thin-film may depend on the embodiment. In some embodiments the film thickness of the thin-film transistors may lie in a range of 1 nm to 100 μm. In some embodiments the film thickness of the thin-film transistors may lie in a range of 0.5 μm to 50 μm. For example, in IGZO is the thin-film thickness is between 10-30nm, such as 12nm or 24nm.

According to a first aspect, there is provided an active thin-film charge sensor element comprising, a charge collecting detector configured to detect a predetermined physical quantity and generate a corresponding intensity signal at an internal charge sensor element node, an amplifier transistor, the amplifier transistor comprising at least one gate that is electrically connected to the charge collecting detector at the internal charge sensor element node, and configured to amplify the intensity signal, a reset transistor, the reset transistor is electrically connected to the internal charge sensor element node and configured to reset the intensity signal, and wherein at least one of the amplifier transistor or reset transistor comprises a front gate and a back gate and wherein the front and back gates are configured to control the amplifier transistor or reset transistor.

According to a second aspect, there is provided a method for controlling an active thin-film charge sensor element comprising the steps of detecting a predetermined physical quantity with a charge collecting detector and generating a corresponding intensity signal at an internal charge sensor element node, amplifying the intensity signal by an amplifier transistor comprising at least one gate that is electrically connected to the charge collecting detector at the internal charge sensor element node, resetting the intensity signal by a reset transistor, the reset transistor is electrically connected to the internal charge sensor element node, and wherein the amplifying and/or resetting is controlled by a front gate and a back gate of the amplifier transistor or reset transistor.

Thanks to the use of the thin-film dual-gate transistors that comprise a front gate and a back gate, an increased performance of the transistor may be achieved. The dual-gate transistor may provide an increased gain with a same amount of transistor area compared to a transistor having only a single gate.

Throughout this application the front gate and back gate are used to describe two different gates of the transistors that follows a most common electrical signal path in a pixel. However, it should also be understood that the front gate and back gate are interchangeable.

Thus, the thin-film dual-gate transistor having the front gate and the back gate may be utilized in order to provide the improved gain of the thin-film dual-gate transistor compared to the single-gate transistor and/or may be utilized in order to have a smaller area of the thin-film dual-gate transistor for a given gain. A smaller area of the thin-film dual-gate transistor may be advantageous in order to decrease a size of the thin-film active charge sensor element, which may enable a small charge sensor element pitch to be used and enable a charge-based sensor with a high resolution.

Signals on the front and/or back gates of the thin-film dual-gate transistor may act together for controlling the transistor. Whereas the signal on the front gate may be based on a desired functionality of the thin-film active sensor element, e.g. the signal on the front gate of the amplifier transistor may be the intensity signal, the signal on the back gate may be provided in various manners.

For instance, the back gate may be connected to the front gate, such that the signal on the back gate may follow the signal on the front gate, which may improve gain of the dual-gate transistor compared to a single-gate transistor.

According to an alternative, a fixed or adjustable voltage signal on the back gate may be provided, which voltage signal on the back gate may control an operating point of the transistor.

The electrical connection of the back-gate of the reset, the select and/or the amplifier transistor can be connected externally of the individual active thin-film charge sensor elements. The external connection removes any internal connections such as a via that could be needed for the back-gate connection with the source drain layer and could therefore simplify the production and use of the active thin-film charge sensor element.

The amplifier transistor may comprise a front gate and a back gate, and the back gate of the amplifier transistor may be electrically connected to the front gate or a select signal line.

The amplifier transistor typically is the transistor having the largest area within an active charge sensor element, since the amplifier transistor is used for amplifying the intensity signal. Therefore, it is particularly advantageous to have an amplifier transistor comprising a front gate and a back gate, because it allows substantially reducing size of the amplifier transistor compared to a single-gate transistor and therefore reduce size of the active charge sensor element.

The back gate of the reset transistor may be electrically connected to the front gate of the reset transistor. When the back gate is connected to the front gate of the reset transistor the on-resistance of the reset transistor is improved compared to a single gate reset transistor. Thus, the size of the reset transistor can be reduced for equivalent on-resistance. Some active charge sensor elements may comprise front and back gates of the amplifier and the reset transistor.

The back gate of the amplifier transistor may be configured to be controlled by an adjustable voltage over time. By changing the voltage at the back gate different transfer characteristics and/or output characteristics of the transistor is achieved. For instance, the current or voltage at the transistor can be regulated for a desired drain current.

Further, a select transistor may be electrically connected to the amplifier transistor. The select transistor may comprise a front and back gate and the front gate of the select transistor is electrically connected to the back gate of the select transistor. As with the other front and back gate connected thin-film transistors the on-resistance of the select transistor is improved resulting in improved readout and amplification of the amplified intensity signal of the charge collecting detector.

Independent on a desired mode of operation of the active thin-film charge sensor element, in a voltage-mode or current-mode, the reset and amplifier transistors are electrically connected to either an anode or cathode side of the charge collecting detector.

In the current-mode a transimpedance or capacitive integration stage is required in the readout, which couples additional noise into the system.

Voltage-mode topologies have better noise performance, although the intensity signal needs a longer time to get transferred from the internal charge sensor element node or front gate of the amplifier transistor to the data line. The voltage-mode has additional advantages: for example, the voltage-mode active thin-film charge sensor element can directly be connected to analog-to-digital circuits, simplifying connected readout circuits.

The active thin-film charge sensor element and thus also the amplifier transistor and/or the reset transistor may be based on an etch-stop layer, backchannel etch and/or self-aligned transistor architecture.

A plurality of the active thin-film charge sensor elements discussed above may be arranged in an charge sensor element array and/or column. The thin-film active charge sensor elements may provide an improvement in gain, which may be utilized as a smaller charge sensor element area for a given gain. Hence, in an array, the active thin-film charge sensor elements may enable a high-resolution charge-based sensor, where the charge sensor element pitch should be small. Further, the use of thin-film technology may also enable largesize charge-based sensors..

The active thin-film charge sensor element may be configured for detecting a predetermined physical quantity (such as for example electromagnetic radiation, a charge, a temperature change, a capacitance, mechanical stress), with the charge collecting detector (for example an electromagnetic detector, an electric detector, a pyroelectric detector, a piezoelectric detector), and generating a corresponding intensity signal at an internal pixel node. The intensity signal is amplified by the amplifier transistor connected to the charge collecting detector at the internal charge sensor element node by providing the intensity signal on one of a front gate or a back gate of the amplifier transistor such that the intensity signal is amplified.

Throughout this application electromagnetic radiation may be visible light, infrared radiation, ultraviolet and/or X-rays. The corresponding electromagnetic detector may then be any type of detector that is configured to or adapted to detect the electromagnetic radiation such as for example an image sensor, infrared sensor, pyroelectric sensor and so on.

As discussed above, an interplay between signals on the front and/or back gates of the thin-film dual-gate transistor acts together for controlling the amplifier transistor. The amplifier transistor may be controlled for different desired purposes and thus have different output characteristics.

The interplay between signals on the front and/or back gates of the thin-film dual-gate transistor could also be applied based on characteristics of the transistor itself such as a switch and/or amplifier, and/or to adapt a threshold voltage of the transistor.

The application of the signal on another of the back gate or the front gate of the amplifier transistor may be the application of a select signal to the back gate of the amplifier transistor. The application of the select signal on the back gate of the amplifier transistor, eliminating the select transistor, will reduce a time from the amplifier transistor to amplify the intensity signal and put the amplified signal on the data line. Hence a faster charge sensor element can be achieved.

To control the different output characteristics the signal applied to the back gate or the front gate of the amplifier transistor may be varied over time. For example, the operation of the active thin-film charge sensor element may be controlled to alternate between an integration period or integration phase at one hand and a readout period or readout phase at the other hand, with a reset phase after each readout phase / before each integration phase. The integration period includes detection of a predetermined physical quantity. A current generated by the charge collecting detector in response to the detected physical quantity is collected on a capacitance at the internal charge sensor element node, thereby charging this internal charge sensor element node capacitance and changing the voltage (intensity signal) at the internal charge sensor element node. The intensity signal may be different at different integration times depending on a number of charges stored on the internal node capacitance resulting from the charge detecting detector. The intensity signal may be applied to the front gate of the amplifier transistor. During the integration period the voltage (intensity signal) at the internal charge sensor element node stays below the threshold voltage of the amplifier transistor, so that there is no amplification of the intensity signal in the integration period. The readout phase includes amplification of the intensity signal (created at the internal charge sensor element node during the integration phase) by the amplifier transistor. During the readout phase a voltage pulse (select signal) is applied to the amplifier transistor, thereby activating the amplifier transistor such that the intensity signal is amplified, and an output signal is generated.

The signal applied on the back gate of the amplifier transistor may be varied depending on a desired current and/or voltage output of the amplifier transistor or other output characteristic.

In some implementations a same signal is applied to the back gate and the front gate of the amplifier transistor for amplifying the intensity signal. The application of the same signal on the front and back gate will improve the gain of the amplifier transistor and thus result in a better signal-to-noise ratio of the amplified intensity signal.

In order to control an integration time of the intensity signal, a reset signal maybe applied to a front and back gate of the reset transistor connected at the internal charge sensor element node.

Still other objectives, features, aspects and advantages of the invention will appear from the following detailed description as well as from the drawings.

Brief Description of the Drawings

Examples of the invention will now be described with reference to the accompanying schematic drawings, in which

Fig. 1 illustrates an active thin-film charge sensor element based on a voltage-mode 2T topology.
Fig. 2 illustrates an active thin-film charge sensor element based on a voltage-mode 3T topology and back gates electrically connected to front gates.
Fig. 3 illustrates an operation of a 2T and 3T topology for amplification of a corresponding intensity signal from a photodetector.
Fig. 4A and 4B illustrate an active thin-film charge sensor element based on a current-mode 2T and 3T topology.
Fig. 5A-5D illustrates 2T topologies based on an active thin-film charge sensor element 10, 5A illustrates a source follower topology, 5B illustrates a source follower variation topology, 5C illustrates a common source topology and 5D illustrates a common source variation topology.
Fig. 6 and Fig. 7 illustrates an example of an active pyroelectric fingerprint sensor, based on the detection of temperature changes.
Fig. 8 illustrates an example of a layer stack of a pyroelectric sensor element, comprising a pyroelectric front plane and a thin-film transistor (TFT) backplane.
Fig. 9 illustrates an array of biochemical sensor elements.
Fig. 10 illustrates a detection mechanism of a biochemical sensor, based on the use of a marker such as a fluorescent marker or a charged marker.
Fig. 11 shows a cross section of an ion-sensitive field-effect transistor (ISFET) that may be used for detecting a charge.
Fig. 12A shows a cross section of a DNA field-effect transistor (DNAFET) for detecting an intrinsic DNA charge.
Fig. 12B schematically illustrates an array of connected biomechanical sensors.
Fig. 13 is a flowchart of a method for controlling an active thin-film charge sensor element.

Detailed Description

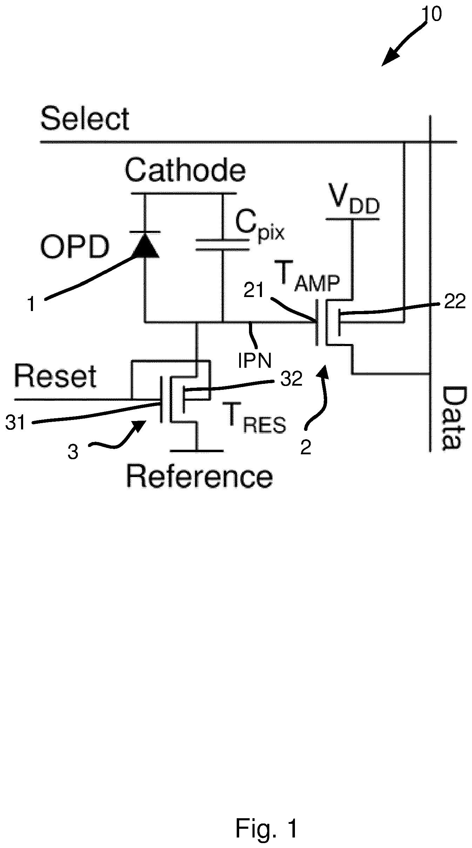

Figure 1 illustrates an active thin-film charge sensor element 10 based on a voltage-mode 2T topology. The active thin-film charge sensor element 10 comprises an electromagnetic detector 1 (charge collecting detector 1). The electromagnetic detector 1 is configured to detect electro-magnetic radiation and generate a corresponding intensity signal at an internal charge sensor element node or internal pixel node IPN. The active thin-film charge sensor element 10 further comprises an amplifier transistor 2. The amplifier transistor 2 is electrically connected to the electromagnetic detector 1 at the internal pixel node IPN and configured to amplify the intensity signal. The active thin-film charge sensor element 10 also comprises a reset transistor 3, the reset transistor 3 is electrically connected to the electromagnetic detector 1 at the internal pixel node IPN and configured to reset the internal charge sensor element node. At least one of the amplifier transistor 2, or reset transistor 3 comprises a front gate 21,31 and a back gate 22, 32 and wherein the front 21, 31 and back gates 22, 32 are configured to control the amplifier transistor 2 or reset transistor 3.

The 2T topology discussed above, based on thin-film technology will reduce the active thin-film charge sensor element area 10 compared to today's single-gate solutions, lowering the charge sensor element pitch for a given performance and/or gain, and increasing the resolution of a fixed size image sensor (charge-based sensor). The use of dual-gate thin-film transistors will also increase the conversion gain for a given size of the charge sensor element 10 compared to thin-film single-gate transistors of a same size.

Further, the 2T topology illustrated in Figure 1 allows for applying a select signal to the back gate 22 of the amplifier transistor 2 which means that - as compared to other topologies - an extra select transistor 4 or capacitance can be omitted, thus reducing the charge sensor element pitch of the charge-based sensor. In this case when the back gate 22 of the amplifier transistor 2 is connected to the select signal, the transconductance of the amplifier transistor 2 is reduced.

The charge collecting detector 1 may be connected to the front and/or the back gate 21,22 of the amplifier transistor 2. The charge collecting detector 1 can also be any type of charge generating detector such as a visible light detector, an infrared detector, a pyroelectric detector, an ultraviolet detector, an X-ray detector, a piezoelectric detector or a charge detector.

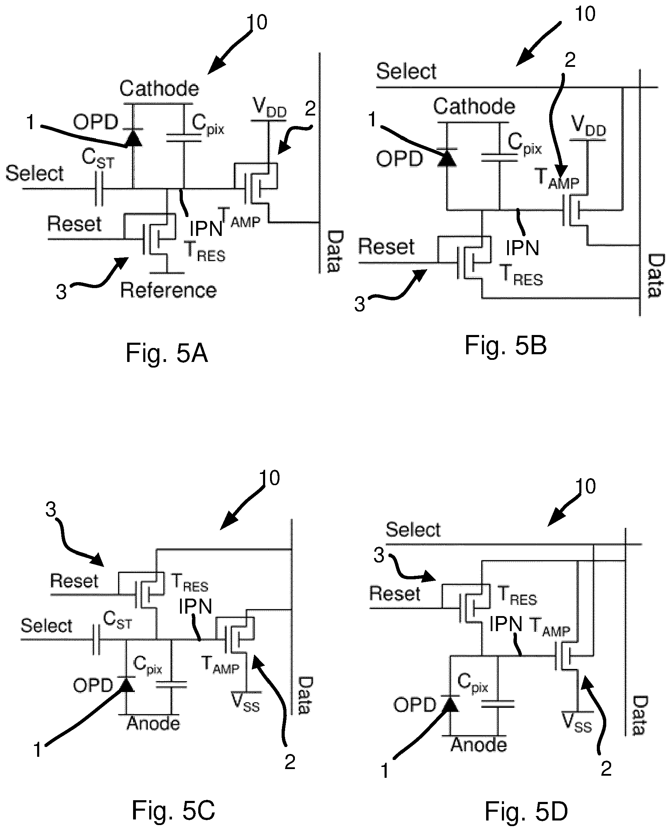

The back gate 22 of the amplifier transistor 2 may be connected to the front gate 21 (not shown in Figure 1) or it may be connected to the select signal line (as illustrated in Figure 1). In case the back gate 22 is connected to the front gate 21 of the amplifier transistor 2, there may be a physical connection inside the charge sensor element 10, as for example illustrated in Figure 5A.

Figure 1 further illustrates an electrical connection between the back gate 32 of the reset transistor 3 and the front gate 31 of the reset transistor 3.

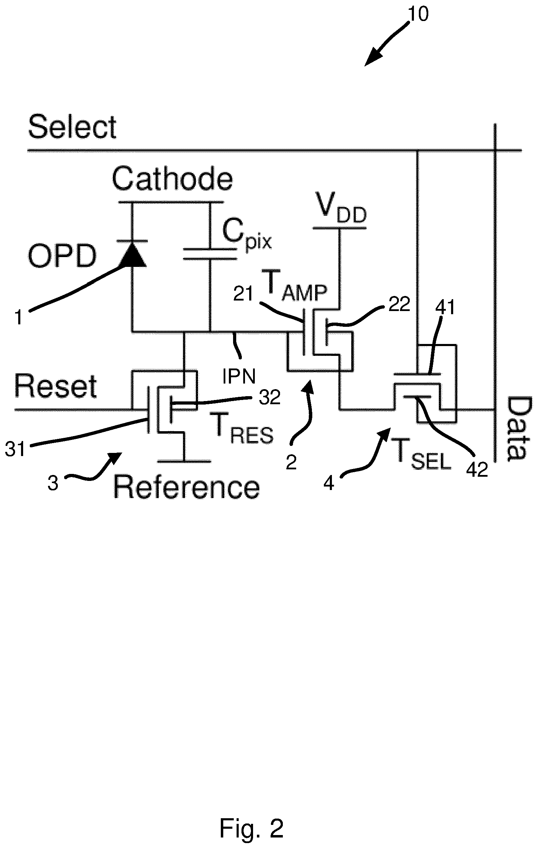

Figure 2 illustrates the active thin-film charge sensor element 10 based on a voltage-mode 3T topology wherein back gates 22,32 of the amplifier and the reset transistor 2,3 are electrically connected to the front gates 21,31 of the amplifier and reset transistor 3. It can also be seen that a select transistor 4 may be electrically connected to the amplifier transistor 2, for example to a source or to a drain of the amplifier transistor 2, and in the illustrated example a front and back gate 41,42 of the select transistor 4 are electrically connected.

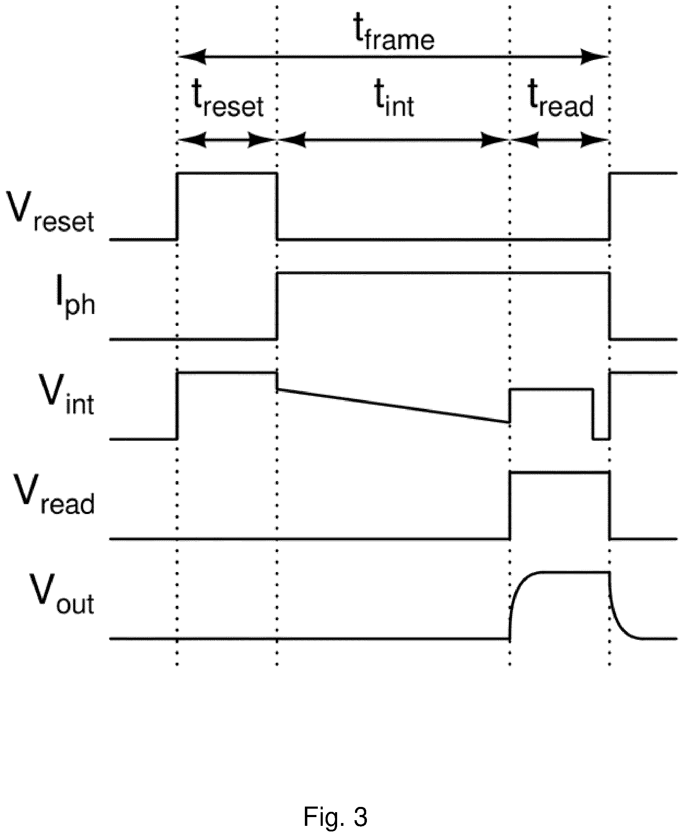

The operation of the 2T and 3T voltage-mode topology, discussed above, is illustrated in Figure 3. Figure 3 illustrates that initially a reset signal is high for a duration of time treset. During that reset time tresest, a select signal is low resulting in a voltage level at the internal charge sensor element node IPN (at the front gate 21 of the amplifier transistor 2) being reset.

During an integration time tint, both reset and select signals are low, and the detection of a physical quantity (e.g. electromagnetic radiation) by the charge collecting detector (e.g.electromagnetic detector) 1 charges the charge sensor element capacitance $C_{PIX}$, thereby generating an intensity signal (voltage signal) at the internal charge sensor element node. When the integration time tint is over, the select signal turns high and the intensity signal resulting from the detected physical quantity (e.g. electromagnetic radiation) by the charge collecting detector (e.g. electromagnetic detector) 1 is amplified by the amplifier transistor 2, thereby generating an output signal on the data line.

The operation is thus the same as today's voltage mode active charge sensor element sensors using transistors formed on a wafer substrate. It would therefore be easy to replace today's active charge sensor element sensors with a plurality of active thin-film charge sensor elements 10, since the drivers and/or logic does not need to be replaced but can be used with possibly minor adjustments.

The amplifier transistor 2 may be configured to be controlled by an adjustable voltage over time. By adjusting the voltage at the back gate 22 or at a source or a drain of the amplifier transistor 2 the amplifier transistor 2 can be controlled to amplify when desired. The adjustable voltage may originate from the select line. This allows for great flexibility and triggering of when the amplifier transistor 2 is to be conductive, i.e. when the amplifier transistor 2 is amplifying the intensity signal.

Additionally, a physical connection of the back gate 32,42 of the reset 3 or select transistor 4, or the back gate 22 of the amplifier transistor 2 can be connected externally of the individual active charge sensor elements 10, i.e. outside of the active charge sensor element 10, allowing for skipping the use of a via that is normally needed to connect a back gate connection with a source drain layer in other types of MOSFETs.

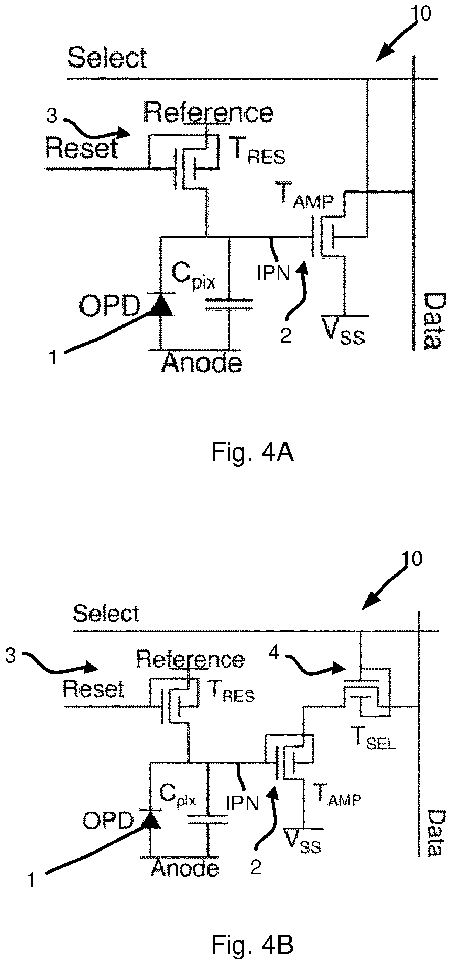

All effects and modes of operation that are discussed above for the 2T and 3T voltage mode topology also applies for the active thin-film charge sensor element 10 based on a current-mode 2T and 3T topology, illustrated in Figures 4A and 4B.

Figures 5A-5D further illustrate other 2T topologies based on the active thin-film charge sensor element 10. Figure 5A illustrates a source follower topology (voltage mode topology), Figure 5B illustrates a variation of this source follower topology, Figure 5C illustrates a common source topology (current mode topology) and Figure 5D illustrates a variation of this common source topology.

In the topologies illustrated in Figures 5B and 5D, an extra capacitance ($C_{ST}$) is omitted compared to the topologies illustrated in Figures 5A and 5C. This presence of a capacitance ($C_{ST}$) increases the size or area of the active charge sensor element 10 and reduces the sensitivity of the active charge sensor element 10. Thus, omitting this capacitance ($C_{ST}$), the performance of the charge sensor element 10 is increased, and higher resolution charge-based sensors can be achieved. Depending on the physical implementation of the charge collecting detector, e.g. electromagnetic detector 1, the amplifier and reset transistors 2,3 are electrically connected to an anode or cathode side of the electromagnetic detector 1.

For the topologies illustrated in Figures 5A-5D, a mode of operation may be that at a beginning of a readout cycle, the front or back gate 21,22 of the amplifier transistor 2 is reset to a voltage on the data line.

During the integration time, a small current from the electromagnetic detector 1 is collected on the internal node capacitance $C_{PIX}$. In Figure 5A, the voltage at the front and back gate 21,22 will increase, whereas in Figure 5C, the voltage will decrease. In either case, the voltage should stay below a threshold voltage (conduction limit) of the amplifier transistor 2 such that there is no amplification by the amplifier transistor 2, either as voltage or as current.

In the readout phase, a voltage and/or current pulse is applied on the select line. This will increase the voltage at the front and back gate 21,22 of the amplifier transistor 2 due to the capacitive coupling caused by the capacitance $C_{ST}$ on the select line.

The voltage at the front and back gate 21, 22 of the amplifier transistor 2 should now be above the threshold voltage of the amplifier transistor 2, and the amplifier transistor 2 is now active and amplifies the intensity signal.

The active thin-film charge sensor element 10 and/or the amplifier transistor 2, the reset transistor 3 may be based on an etch-stop layer, backchannel etch and/or self-aligned transistor architecture.

As discussed above, a charge-based sensor, e.g. an image sensor, may comprise a plurality of active thin-film charge sensor elements, e.g. active thin-film pixels 10. The charge-based sensor may comprise rows and/or columns of the active thin-film charge sensor elements 10.

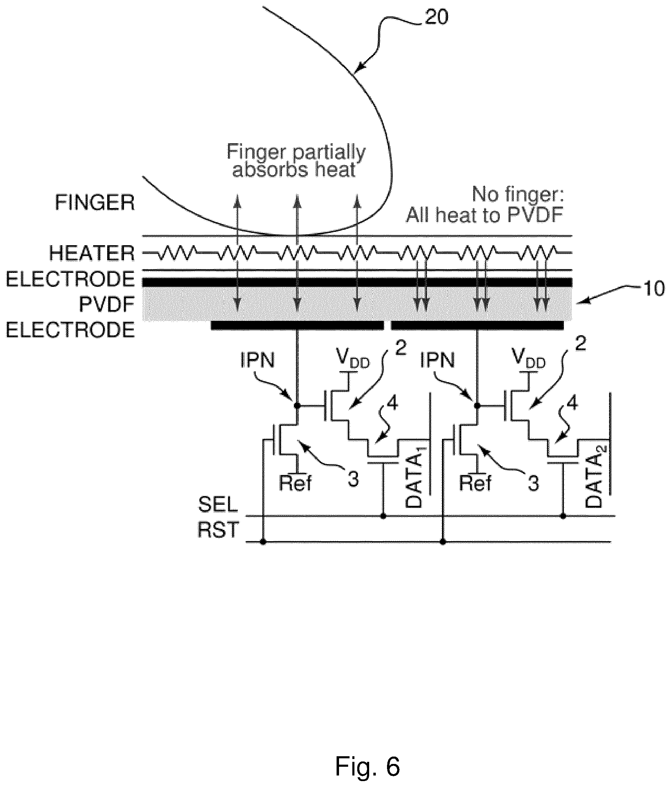

The active thin-film charge sensor element 10 may also be used in a fingerprint sensor. An example of such a fingerprint sensor is illustrated in figure 6. The fingerprint sensor may be of an active thermal or passive thermal type. In a passive thermal type of fingerprint sensor, the active thin-film charge sensor element 10 is configured to detect changes in temperature caused by a presence of a finger 20 and generate charges. After a while, the temperature of the active thin-film charge sensor element 10 settles to the temperature of the finger, and the generation of charges stops.

In an active fingerprint sensor type, a small quantum of heat Q_is injected at the same location as the active thin-film charge sensor element 10, and the local thermal mass is observed. When a fingerprint ridge is present, a higher thermal mass is observed, and a lower temperature increase $\Delta T$ is observed for a given heat Q, which then generates charges.

Figure 6 illustrates a pyroelectric fingerprint sensor of an active type comprising of an array of active thin-film charge sensor elements 10. A pyroelectric layer will generate charges $\Delta Q$ depending on the temperature change $\Delta T$:

$$\Delta Q = p \ A \ \Delta T$$

Wherein A is the area of the layer and p is a material dependent pyroelectric coefficient. An example of the pyroelectric material is a Poly-VinylDiFluoride - Tri-FluoroEthylene (PVDF-TrFE), which is sometimes abbreviated as PVDF.

The pyroelectric material, PVDF, combined with the electrodes can be considered analogous to the OPD in Figures 1-5D and thus will generate charges on the internal sensor element node IPN.

As discussed above and illustrated in Figure 6, when the finger is placed above the heater, the finger will partially absorb heat from the heater. The remaining heat will spread to the PVDF material and result in a lower generation of charges compared to other areas of the PVDF material where the finger is not present. By dividing an electrode layer on one side of the PVDF material into fixed size isolated areas it is possible to generate a matrix or array of active thin-film charge sensor elements 10 for finger detection over a surface such as a mobile phone screen. Hence, similar to optical large-area optical imagers, the active thin-film charge sensor elements 10 can be arranged in a large array.

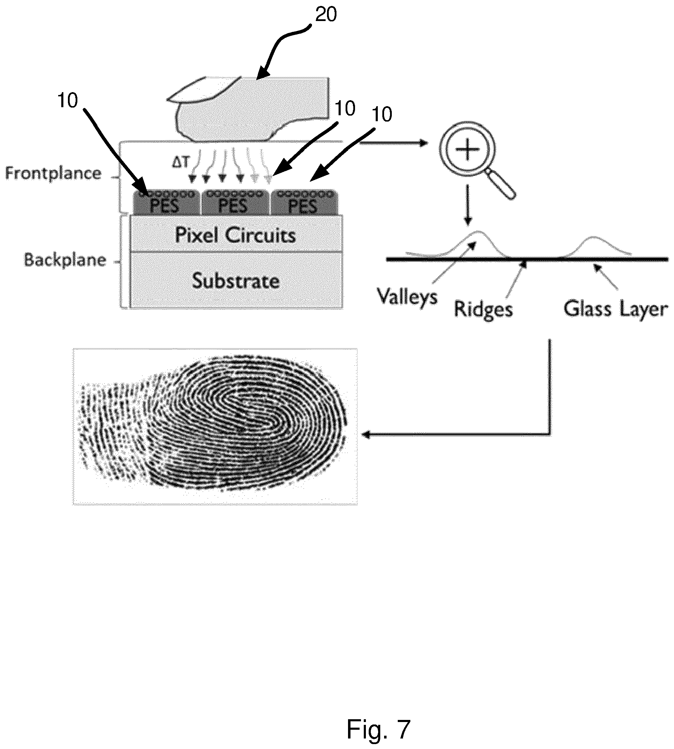

Illustrated in Figure 7, the array of active thin-film charge sensor elements 10 is arranged in a front plane. The output of the front plane is a quantum of charge Q for each active thin-film charge sensor element 10, typically expressed in number of electrons. The collected charges are processed by a backplane, which consists of active thin-film charge sensor element 10 circuits and peripherals. A purpose of the backplane is to quantize the charges Q as accurate and fast as possible for the full array.

The charges may be further processed and possibly also similarly processed as discussed above in relation to optical imagers, i.e. the backplane is agnostic to how the charges are generated.

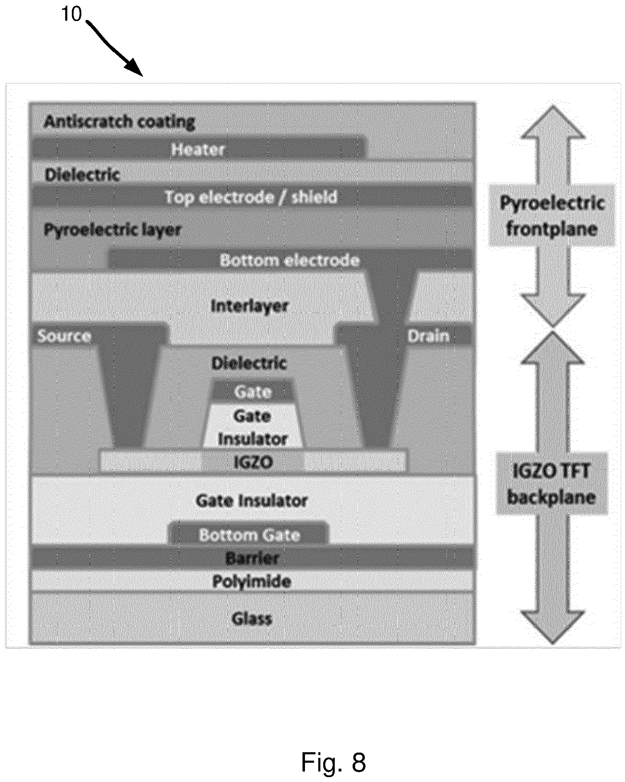

The front plane and backplane may be arranged as illustrated in Figure 8. Figure 8 illustrates a layer stack of the front plane and backplane of one active thin-film charge sensor element 10. This stack layer uses a soluble PVDF-based pyroelectric material as the active layer. In the active layer the temperature increase is translated into charges, which in turn creates a current that charges or discharges a node where the backplane and the bottom electrode are connected, depending on the polarity of the active thin-film charge sensor element 10.

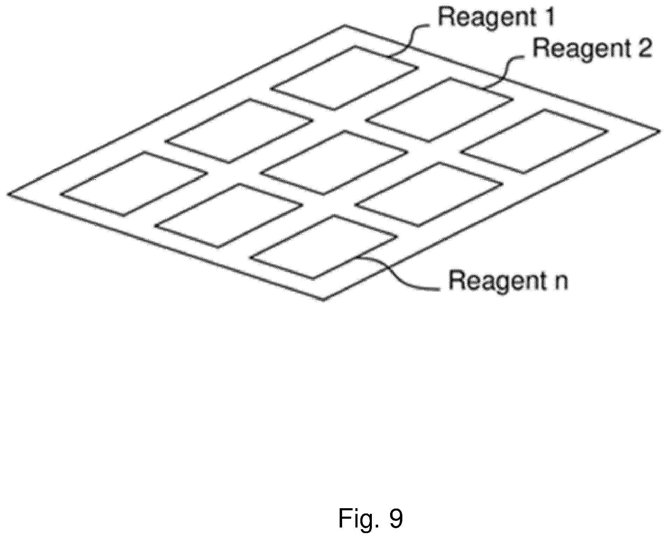

The active thin-film charge sensor element 10 may also be used in a biochemical detector application. The biochemical detector may comprise a plurality of active thin-film charge sensor elements 10 arranged in an array or matrix configuration also known as an assay, illustrated in Figure 9.

The active thin-film charge sensor elements 10 in the assay may be doped or prepared with different detection chemicals, which react to different analytes and then generates charges. This allows for a sample to be analyzed having different types of molecules or analytes, of which the presence is to be detected.

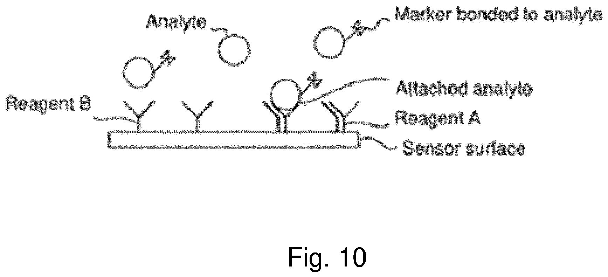

To ensure proper localization, the local reagent is fixed to the substrate in each sensor element (pixel), e.g. by chemically bonding to the surface there. There are several ways to measure whether a reaction has taken place at a specific site / pixel after the sample is applied to the assay. Most detection methods use some kind of marker which is attached to the molecules in the sample to indicate their presence. This marker can be a fluorescent complex or an electric charge. Figure 10 illustrates a possible scenario at the surface of the at the active thin-film charge sensor element 10.

Two pixels are shown, one with reagent A, and the other with reagent B. The analyte bonds to reagent A only, bringing the marker close to the surface of the sensor.

After the sample is applied to the surface, the sample is cleaned / washed again, so that only the attached analytes remain at each pixel.

Depending on the type of the marker, different readout methodologies can be used. For a fluorescent marker, optical techniques can be used, like laser scanning, or an integrated optical sensor array, i.e. a large-area imager.

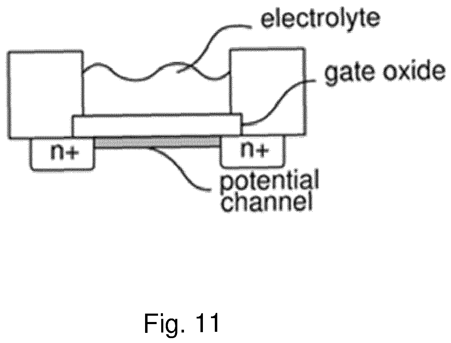

Illustrated in Figure 11 is an example of a setup for an electrical readout when the marker is charged. A typical example of this concept is the ion-sensitive field-effect transistor (ISFET). An ISFET is typically used for measuring local pH, by checking the local charge caused by the acidity of the fluid. Here, this charge is used to bring a semiconductor in inversion / accumulation, thereby opening a FET channel.

Other types are e.g. the DNAFET, where DNA is matched with DNA strands fixed to the surface, and the intrinsic charge of the DNA is used to bias a gate of a nanowire transistor.

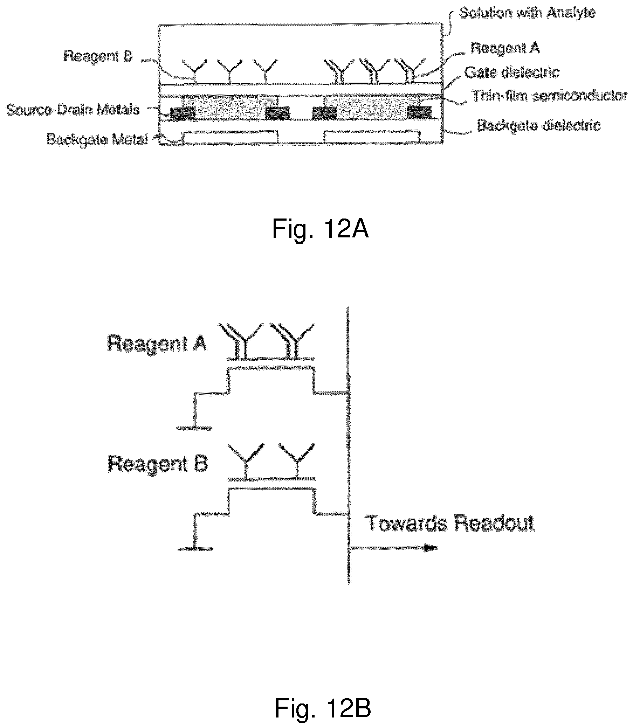

Another example based on the active thin-film charge sensor element 10 is a large-area platform comprising an array comprising a semiconductor material being a thin-film semiconductor. This would be another charge-based sensor, where it would be possible to measure charges on the internal node IND, but the internal node IND is a top surface of a DNA-covered surface. An example of this configuration is illustrated in Figures 12A and 12B.

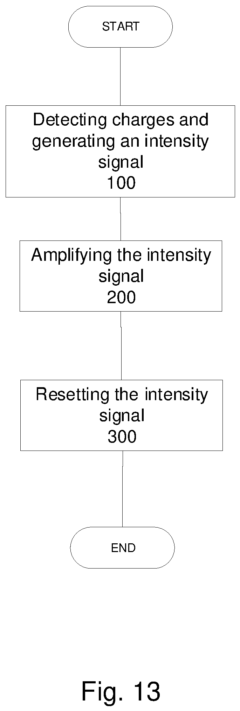

Figure 13 illustrates a method for controlling the active thin-film charge sensor element 10. The method comprises detecting 100 a predetermined physical quantity with a charge collecting detector 1 of the charge sensor element 10 and generating a corresponding intensity signal at an internal charge sensor element node IND. Amplifying 200 the intensity signal by an amplifier transistor 2 comprising at least one gate that is electrically connected to the charge collecting detector 1 at the internal charge sensor element node IND.

Resetting 300 the intensity signal by a reset transistor 3, the reset transistor is electrically connected to the internal charge sensor element node IND, and wherein the amplifying 200 and/or resetting 300 is controlled by a front gate and a back gate of the amplifier transistor 2 or reset transistor 3.

A reset signal may be applied to a gate of the amplifier transistor 2 for resetting the intensity signal.

From the description above follows that, although various examples of the invention have been described and shown, the invention is not restricted thereto, but may also be embodied in other ways within the scope of the subject-matter defined in the following claims.

## Claims

1. An active thin-film charge sensor element comprising,

   - a charge collecting detector configured to detect a predetermined physical quantity and generate a corresponding intensity signal at an internal charge sensor element node,
   - an amplifier transistor, the amplifier transistor comprising at least one gate that is electrically connected to the charge collecting detector at the internal charge sensor element node, and configured to amplify the intensity signal,
   - a reset transistor, the reset transistor is electrically connected to the internal charge sensor element node and configured to reset the intensity signal, and
   wherein at least one of the amplifier transistor or reset transistor comprises a front gate and a back gate and wherein the front and back gates are configured to control the amplifier transistor or reset transistor.

2. A charge sensor element according to claim 1, wherein the amplifier transistor comprises a front gate and a back gate, and wherein the back gate of the amplifier transistor is electrically connected to the front gate or a select signal line.

3. A charge sensor element according to claim 1 or 2, wherein the reset transistor comprises a front gate and a back gate, and wherein the back gate of the reset transistor is electrically connected to the front gate of the reset transistor.

4. A charge sensor element according to any one of the preceding claims, wherein each of the amplifier transistor and the reset transistor comprises front and back gates.

5. A charge sensor element according to any one of the preceding claims, wherein the back gate of the amplifier transistor is configured to be controlled by an adjustable voltage over time.

6. A charge sensor element according to any one of the preceding claims, further comprising a select transistor electrically connected to the amplifier transistor, the select transistor comprises a front and back gate, and the front gate of the select transistor is electrically connected to the back gate of the select transistor.

7. A charge sensor element according to any one of the preceding claims, wherein the reset and amplifier transistors are electrically connected to an anode or cathode side of the charge collecting detector.

8. A charge sensor element according to claim 1, wherein the amplifier transistor and the reset transistor are based on an etch-stop layer, backchannel etch and/or self-aligned transistor architecture.

9. A charge sensor element according to any one of the preceding claims, wherein the charge collecting detector is a photodetector, a pyroelectric sensor, an ion-sensitive field-effect transistor or a bio-sensitive field-effect transistor.

10. A charge sensor element array, comprising a plurality of charge sensor elements according to any one of claims 1-9.

11. A method for controlling an active thin-film charge sensor element comprising:

- detecting a predetermined physical quantity with a charge collecting detector of the charge sensor element and generating a corresponding intensity signal at an internal charge sensor element node,
- amplifying the intensity signal by an amplifier transistor comprising at least one gate that is electrically connected to the charge collecting detector at the internal charge sensor element node,
- resetting the intensity signal by a reset transistor, the reset transistor is electrically connected to the internal charge sensor element node, and wherein the amplifying and/or resetting is controlled by a front gate and a back gate of the amplifier transistor or reset transistor.

12. A method according to claim 11 further comprising the step of:

- applying a select signal to the other one of the back gate or the front gate of the amplifier transistor.

13. A method according to claim 11 or 12, wherein the signal applied to the back gate or the front gate of the amplifier transistor is varied over time.

14. A method according to any one of claims 11-13, wherein a same signal is applied to the back gate and the front gate of the amplifier transistor for amplifying the intensity signal.

15. A method according to any one of claims 11-14 further comprising the step of:

- applying a reset signal to a front and back gate of a reset transistor electrically connected to the charge collecting detector and the amplification transistor, for resetting the intensity signal.

Fig. 1

10

Select

Cathode

OPD

$C_{pix}$

$V_{DD}$

1

21 $T_{AMP}$

22 41

Reset

IPN

32

31

$T_{RES}$

2

$T_{SEL}$ 42

3

Reference

4

Data

Fig. 2

Fig. 3

Fig. 4A

Fig. 4B

Fig. 5A

Fig. 5B

Fig. 5C

Fig. 5D

Fig. 6

Fig. 7

10

Fig. 8

Fig. 9

Fig. 10

Fig. 11

Fig. 12A

Fig. 12B

START

Detecting charges and
generating an intensity
signal
100

Amplifying the intensity
signal
200

Resetting the intensity
signal
300

END

Fig. 13

Europäisches
Patentamt
European
Patent Office
Office européen
des brevets

# EUROPEAN SEARCH REPORT

**Application Number**

EP 21 17 1195

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/075593 A1 (WILLIAMS JR GEORGE MELVILLE [US]) 28 March 2013 (2013-03-28) <br><br> * paragraph [0051] – paragraph [0054]; figure 7a * <br> ----- | 1,4,5, 7-11,13, 15 | INV.<br>H04N5/3745<br>H01L27/146<br>G01N27/414 |
| X <br><br> Y | US 2017/013214 A1 (OHMARU TAKURO [JP]) 12 January 2017 (2017-01-12) <br> * paragraph [0116]; figures 7a-7c * <br> ----- | 1-4,6,7, 9-12,14 <br><br> 2 | |
| Y | CN 111 083 399 A (UNIV SUN YAT-SEN) 28 April 2020 (2020-04-28) <br> * paragraph [0031]; figures 2-5 * <br> ----- | 2 | |
| L | WO 02/19396 A1 (WIRELESS SYSTEMS INC [US]; PARKE STEPHEN A [US]) 7 March 2002 (2002-03-07) <br> * paragraph [0098] – paragraph [0101] * <br> ----- | 8 | |
| X | CN 110 460 786 A (BOE TECHNOLOGY GROUP CO LTD) 15 November 2019 (2019-11-15) <br> * the whole document * <br> ----- | 1,11 | **TECHNICAL FIELDS SEARCHED (IPC)**<br><br>H04N<br>H01L<br>G01N |

The present search report has been drawn up for all claims

| Place of search | Date of completion of the search | Examiner |
|---|---|---|
| Munich | 16 September 2021 | Penchev, Petyo |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
...............................................................................................
& : member of the same patent family, corresponding
   document

EPO FORM 1503 03.82 (P04C01)

Europäisches
Patentamt

European
Patent Office

Office européen
des brevets

**Application Number**

**EP 21 17 1195**

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

**see sheet B**

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

**1-8, 11-15(completely); 9, 10(partially)**

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

**EP 21 17 1195**

The Search Division considers that the present European patent application does not comply with the requirements of unity of invention and relates to several inventions or groups of inventions, namely:

```
1. claims: 1-8, 11-15(completely); 9, 10(partially)

      An active thin-film charge sensor element comprising a
      photodetector
                          ---


2. claims: 9, 10(partially)

      An active thin-film charge sensor element comprising a
      pyroelectric sensor
                          ---


3. claims: 9, 10(partially)

      An active thin-film charge sensor element comprising an
      ion-sensitive field-effect transistor
                          ---


4. claims: 9, 10(partially)

      An active thin-film charge sensor element comprising a
      bio-sensitive field-effect transistor
                          ---
```

## ANNEX TO THE EUROPEAN SEARCH REPORT
## ON EUROPEAN PATENT APPLICATION NO.

EP 21 17 1195

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2021

| Patent document cited in search report | | Publication date | Patent family member(s) | | Publication date |
|---|---|---|---|---|---|
| US 2013075593 | A1 | 28-03-2013 | US | 8319307 B1 | 27-11-2012 |
| | | | US | 2013075593 A1 | 28-03-2013 |
| US 2017013214 | A1 | 12-01-2017 | JP | 6734132 B2 | 05-08-2020 |
| | | | JP | 6960025 B2 | 05-11-2021 |
| | | | JP | 2017022706 A | 26-01-2017 |
| | | | JP | 2020182228 A | 05-11-2020 |
| | | | TW | 201707440 A | 16-02-2017 |
| | | | TW | 202127864 A | 16-07-2021 |
| | | | US | 2017013214 A1 | 12-01-2017 |
| CN 111083399 | A | 28-04-2020 | CN | 111083399 A | 28-04-2020 |
| | | | WO | 2021128595 A1 | 01-07-2021 |
| WO 0219396 | A1 | 07-03-2002 | AU | 8689501 A | 13-03-2002 |
| | | | EP | 1319242 A1 | 18-06-2003 |
| | | | JP | 2004517466 A | 10-06-2004 |
| | | | KR | 20030061791 A | 22-07-2003 |
| | | | US | 2002192911 A1 | 19-12-2002 |
| | | | WO | 0219396 A1 | 07-03-2002 |
| CN 110460786 | A | 15-11-2019 | NONE | | |

EPO FORM P0459

For more details about this annex : see Official Journal of the European Patent Office, No. 12/82